Europäisches Patentamt

European Patent Office

Office européen des brevets

(11) Veröffentlichungsnummer: 0 132 704
A2

# EUROPÄISCHE PATENTANMELDUNG

(21) Anmeldenummer: 84108169.8

(22) Anmeldetag: 12.07.84

(51) Int. Cl.⁴: **H 01 R 9/09**

(30) Priorität: 23.07.83 DE 3326598
16.02.84 DE 3405554

(43) Veröffentlichungstag der Anmeldung:
13.02.85 Patentblatt 85/7

(84) Benannte Vertragsstaaten:
AT BE CH DE FR GB IT LI NL SE

(71) Anmelder: EPT Elektronische Präzisionsteile GmbH & Co.
Bergwerkstrasse 50
D-8922 Peiting(DE)

(72) Erfinder: Guglhör, Bernhard
Kulturenweg 11
D-8959 Buching(DE)

(74) Vertreter: Bockhorni, Josef, Dipl.-Ing. et al,
Plinganserstrasse 18a Postfach 70 02 09
D-8000 München 70(DE)

(54) Kontaktstift für elektronische Bauteile, insbesondere Leiterplatten.

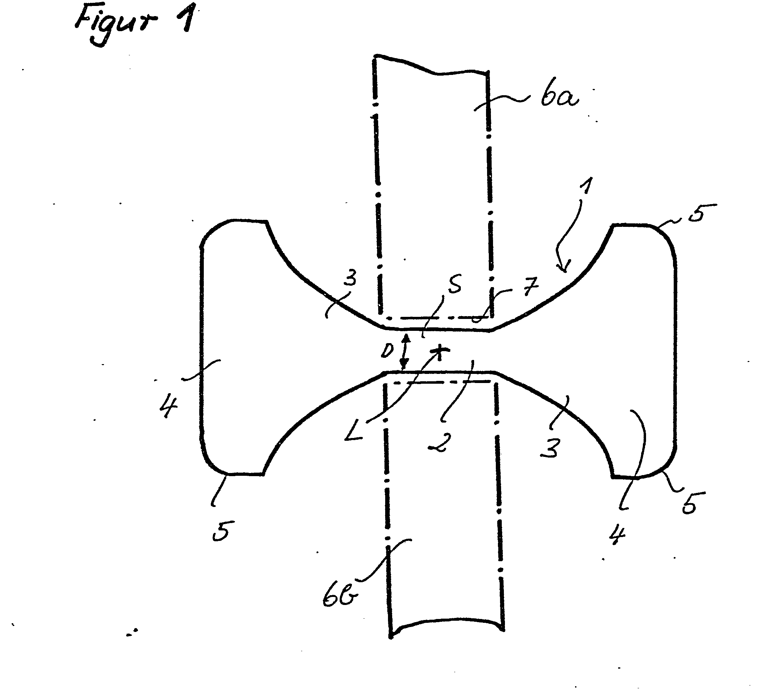

(57) Bei einem Kontaktstift für elektronische Bauteile, insbesondere Leiterplatten, der mit Preßsitz in eine Öffnung der Leiterplatte einsteckbar ist, wobei der Sitzabschnitt des Stifts in der Leiterplatte mit mindestens zwei Außenabschnitten am Rand der Leiterplattenöffnung anliegt, ist der Kontaktstift im Sitzabschnitt (1) mit einer zentralen Stauchungszone (S) versehen, die sich im wesentlichen über die Länge des Sitzabschnitts erstreckt (Figur 1).

Figur 1

Croydon Printing Company Ltd.

EP 0 132 704 A2

4690 Herne 1,
Schaeferstraße 18
Postfach 1140
Pat.-Anw. Herrmann-Trentepohl
Fernsprecher: 0 23 23 / 5 10 13
5 10 14

Telegrammanschrift
Bahrpatente Herne
T e l e x 08 229 853

Dipl.-Ing. R. H. Bahr (1931-1981)
Dipl.-Phys. Eduard Betzler
Dipl.-Ing. W. Herrmann-Trentepohl
Dipl.-Ing. Josef Bockhorni
PATENTANWÄLTE
PROFESSIONAL REPRESENTATIVES
BEFORE THE EUROPEAN PATENT OFFICE

'0132704

Telegrammanschrift.
Babotzpat München
T e l e x 5215360
Telefax 089/79 89 88

Bankkonten:
Bayerische Vereinsbank München 952 287
BLZ 700 202 70
Dresdner Bank AG Herne 7-520 499
BLZ 432 800 84
Postscheckkonto Dortmund 558 68-467
BLZ 440 100 46

Ref.: M 07 975 Bo/i
In der Antwort bitte angeben

Zuschrift bitte nach:
München

10. Juli 1984

EPT Elektronische Präzisionsteile GmbH & Co.
8922 Peiting

## Kontaktstift für elektronische Bauteile, insbesondere Leiterplatten

Die Erfindung betrifft einen Kontaktstift für elektronische Bauteile, insbesondere Leiterplatten gemäß dem Oberbegriff von Patentanspruch 1 bzw. 7.

Kontaktstifte werden in erheblichen Mengen für die Herstellung elektronischer Bauteile verwendet, insbesondere für Leiterplatten, in deren Öffnungen die Kontaktstifte eingesteckt werden.

Um einen festen Sitz der Kontaktstifte in den entsprechenden Öffnungen der Leiterplatte zu gewährleisten, ist es bekannt, die Kontaktstifte mittels Schwallöten zu befestigen. Jedoch ist der Lötvorgang vergleichsweise aufwendig und erschwert die Lötverbindung ein Herausnehmen der Steckerstifte, falls dies aus Reparaturgründen erfor-

-2-

derlich ist. Der wesentliche Nachteil einer Schwallötbefestigung besteht allerdings in der damit einhergehenden Erwärmung der Leiterplatte, was zu Schädigungen der Leiterplatte führen kann.

Um diese Nachteile zu beheben, ist man auf den Einsatz von Kontaktstiften übergegangen, die einen durch einen Prägevorgang hergestellten Sitzabschnitt aufweisen, über welchen sie in der entsprechenden Öffnung in der Leiterplatte verankert sind. Bei einem bekannten Kontaktstift dieser Bauart (US-PS 4 223 970) sind durch zwei in den Drahtquerschnitt eingebrachte Längsnuten zwei Außenabschnitte begrenzt, die spitze Außenkanten aufweisen, mit denen sich der Kontaktstift in den Rand der Öffnungen festkrallt. Durch die beiden längs verlaufenden Nuten werden ferner Gelenkstellen im zentralen Bereich des Sitzabschnitts gebildet, um welche die Außenabschnitte beim Einsetzen des Kontaktstiftes in die Öffnung der Leiterplatte nachgiebig zurückschwenken können. Derartige Kontaktstifte mit flexiblem Sitzabschnitt besitzen gegenüber den starr durch Schwallöten befestigten Kontaktstiften Vorteile, sie haben sich jedoch infolge der innewohnenden Flexibilität auch als nachteilhaft erwiesen, weil sich die Stärke des Preßsitzes nicht zuverlässig vorausbestimmen läßt.

Aufgabe der Erfindung ist es, einen Kontaktstift zu schaffen, der einen Toleranzausgleich bewirkt und dennoch zuverlässig fest innerhalb der Bohrung sitzt und den Festsitz auch noch nach langer Einsatzzeit des Bauteils gewährleistet.

Diese Aufgabe wird erfindungsgemäß durch die im kennzeichnenden Teil des Anspruchs 1 bzw. 7 enthaltenen Maßnahmen gelöst, wobei zweckmäßige Ausgestaltungen der Erfindung durch die in den Unteransprüchen enthaltenen Merkmale gekennzeichnet sind.

Die Erfindung gemäß Anspruch 1 bringt eine Abkehr von den in der jüngsten Zeit vermehrt eingesetzten Kontaktstiften mit flexiblen Sitzabschnitten, indem sie grundsätzlich zum starren Prinzip übergeht und damit eine stabile Verankerung des Kontaktstifts innerhalb der Leiterplattenöffnung erzielt. Dies wird erreicht durch eine zentral angeordnete Stauchungszone, in welcher beim Einpressen des Stifts in die Leiterplattenöffnung konzentriert eine weitgehend rein plastische Verformung durch Materialfluß stattfindet. Nach dem Einbringen des Kontaktstifts und der erfolgten bleibenden Verformung im zentralen Stiftbereich sitzt der Kontaktstift fest und starr innerhalb der entsprechenden Leiterplattenöffnung. Durch die plastische Materialumformung in der Stauchungszone können Toleranzunterschiede ohne weiteres kompensiert werden. Ferner ist eine schonende Kontaktierung der Öffnungswand gewährleistet, so daß ein daran angeordneter Überzug nicht beschädigt wird. Ferner läßt sich die Stärke des Preßsitzes zuverlässig vorausbestimmen. Der Kontaktstift bietet den Vorteil, daß die Stauchungszone ein weitergehendes Zurückweichen der Anlageabschnitte des Sitzabschnitts ausschließt, wie es andererseits bei den Kontaktstiften mit federnden Anlageabschnitten der Fall ist.

In vorteilhafter Weise ist die Stauchungszone durch einen Steg mit zu den übrigen Abmessungen des Sitzabschnitts geringer Dicke gebildet. Dadurch wird die Stauchungszone zuverlässig in den Steg verlagert. Durch entsprechende Wahl der Stegdicke läßt sich die plastische Verformung in der Stauchungszone regulieren. Gleichzeitig läßt sich hierdurch eine weitgehend schonende Einwirkung der Außenabschnitte auf die Öffnungswand und einen dort angebrachten Überzug verwirklichen. Bei Verwendung eines gleichmäßig dicken Steges kommt es beim Einpressen des Kontaktstifts in die entsprechende Leiterplattenöffnung zu einer balligen Ausformung des Stegs.

Besonders vorteilhaft ist es ferner, daß die Außenabschnitte des Sitzabschnitts durch die Stauchungszone miteinander verbunden sind und die Außenabschnitte abgerundete Außenkanten für den Kontakt mit dem Rand der Leiterplattenöffnung aufweisen. Aufgrund der abgerundeten Außenkanten wird eine Verformung im Kontaktbereich zwischen dem Kontaktstift und der Leiterplattenöffnung vermieden, die nur im Bereich des Steges stattfindet. Das heißt, die abgerundeten Außenkanten bedingen eine Verlagerung des Materialflusses beim Pressen des Kontaktstifts in den zentralen Bereich, in welchem sich die Stauchungszone befindet.

Bei einem weiteren vorteilhaften Kontaktstift, der eine elastisch deformierbare Einpreßzone aufweist, ist in vorteilhafter Weise der Übergang vom Steg zu den Schenkeln durch eine Rundung gebildet, die sich vom jeweiligen Stegende bis in die ballige Kontaktzone fortsetzt. Diese Maßnahmen begünstigen das federelastische Verhalten des Kontaktstiftes, so daß auch nach längeren Betriebszeiten (Steckzeiten) und auch bei entsprechenden Toleranzmaßen des Öffnungsdurchmessers ein Lockern des Festsitzes ausgeschlossen ist. Dies wird maßgeblich dadurch erreicht, daß zwei Gelenkpunkte vorhanden sind, gleichwohl jedoch die äußeren Abschnitte des Steckerstiftes so ausgebildet sind, daß eine Zerstörung der Oberflächen der Öffnungswand der Leiterplatten nicht eintritt. Auch bei stärkeren Deformationen des Kontaktstiftes, die insbesondere dann auftreten, wenn große Toleranzmaße mit dem Kontaktstift überbrückt werden sollen, ist somit ein ausreichend federelastisches Verhalten des Kontaktstiftes gewährleistet. Die spezielle Formgebung schließt hierbei eine Beschädigung einer plattierten Fläche der Öffnungswand der Leiterplatten aus und zwar auch bei hohen Preßkräften.

Nachfolgend werden Ausführungsbeispiele der Erfindung anhand der Zeichnung beschrieben. Darin zeigen

Fig. 1 schematisch eine Schnittansicht durch einen Sitzabschnitt eines mit einer Stauchungszone versehenen Kontaktstifts quer zur Stiftachse sowie

Fig. 2 eine Schnittansicht einer anderen Ausführungsform eines Kontaktstifts quer zur Stiftachse, wobei der Kontaktstift eine elastisch deformierbare Einpreßzone aufweist.

Die Figur 1 zeigt den Querschnitt (Grundriß) eines Sitzabschnitts eines Kontaktstifts für Leiterplatten, mit welchem der Kontaktstift mit Preßsitz in einer Öffnung mit kreisrundem Querschnitt in einer Leiterplatte aufgenommen ist. Wie die Schnittdarstellung zeigt, besitzt der allgemein mit 1 bezeichnete Sitzabschnitt einen eine vorbestimmte Stauchungszone S darstellenden Steg 2, der zentral angeordnet ist und sich längs der Stiftachse L im wesentlichen über die axiale Länge des Sitzabschnittes 1 erstreckt. Ferner erstreckt sich der Steg 1 im dargestellten Schnitt radial zur Längsachse L des Kontaktstifts und weist über die gesamte radiale Breite sowie die axiale Länge des Stegs 2 eine gleichmäßige Dicke D auf. Die durch den zentralen Steg 2 gebildete Stauchungszone S geht über im Grundriß trompetenförmige Übergangsabschnitte 3 in Außenabschnitte 4 über, die zur Anlage am Rand der Öffnung der Leiterplatte dienen. Die beiden Außenabschnitte 4 sind radial einander gegenüberliegend angeordnet und besitzen zwei abgerundete Außenkanten 5, über welche sie beim Einpressen des Kontaktstifts in die Leiterplatte mit dem Rand der Leiterplattenöffnung in Preßkontakt gelangen. Die Außenabschnitte 4 besitzen einen im wesentlichen rechteckigen Grundriß, bei dem die beiden Außenkanten abgerundet sind.

Der Sitzabschnitt 1 ist durch Prägen eines Drahtmaterials hergestellt, welches im wesentlichen quadratischen oder rechteckförmigen Querschnitt besitzt. Das Prägen erfolgt mittels zweier einander gegenüberliegender Stempel 6a und 6b, wobei die Breite der Stempelfläche 7 im wesentlichen der radialen Abmessung des Stegs 2 entspricht, wie die Figur ohne weiteres zeigt.

Beim Einpressen des Kontaktstifts in die Öffnung der Leiterplatte kommt es zu einem Materialfluß nur im Bereich des Stegs 2, der sich unter Stauchung plastisch verformt und ballig wird. Aufgrund der gelenkten plastischen Umformung im Bereich des Steges 2 handelt es sich um einen starren Preßsitz. Bei einem verbleibenden geringen Anteil an elastischer Verformung im Bereich des Stegs 2 wirkt ferner eine federnde Rückstellkraft auf die beiden Außenabschnitte 4 . Durch die Stauchung des Steges 2 können Toleranzabweichungen auf Seiten des Kontaktstifts bzw. der Öffnung der Leiterplatten kompensiert werden. Je nach Stegdicke und Stegform kann der Grad der plastischen Verformung und damit die Stärke des Preßsitzes bzw. der Bereich, nach welchem eine Kompensation stattfinden kann, reguliert werden. Für das Verfahren eignet sich insbesondere ein Drahtmaterial, welches bereits abgerundete Außenkanten besitzt.

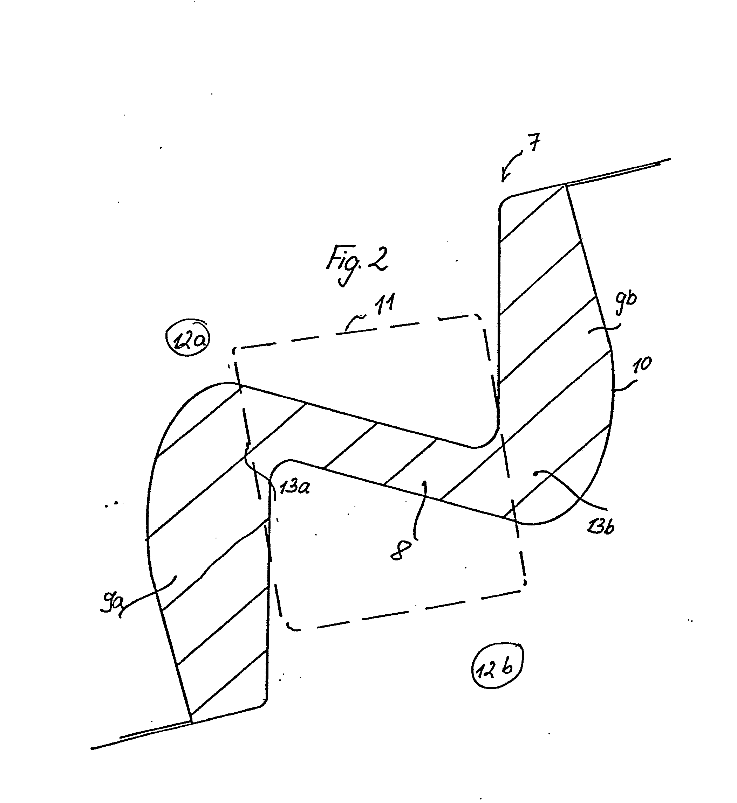

Fig. 2 zeigt einen Querschnitt der Einpreßzone 7 eines Kontaktstifts. Danach besitzt die Einpreßzone des Kontaktstifts eine S- oder Z-Querschnittsform. Im einzelnen untergliedert sich die Querschnittsform in einen Steg 8, an dessen beiden Enden Schenkel 9a und 9b in gegenüberliegenden Richtungen abstehen, um somit die S- oder Z-Grundform der Einpreßzone 7 zu bilden.

Bei dem speziell dargestellten Ausführungsbeispiel ist der Übergang vom Steg 8 zu den Schenkeln 9a, 9b am Außenumfang gerundet. Ferner geht der Außenumfang an der Schenkelaußenseite in einen balligen Abschnitt bei 10 über. Schließlich verjüngt sich ein jeder Schenkel 9a, 9b zu seinem freien Ende hin. Im dargestellten Ausführungsbeispiel ist dies durch die ballige Ausführung der Außenseite der Schenkel bedingt, wobei die Innenseite der Schenkel geradlinig verläuft, um ein Klemmen mit dem Prägewerkzeug zu unterbinden. Aus diesem Grund erstreckt sich die Innenseite der Schenkel 9a, 9b relativ zum Steg 8 unter einem die Entformung begünstigenden Winkel, der im dargestellten Ausführungsbeispiel etwa 75° beträgt.

Wie ferner aus Fig. 2 ersichtlich, erstreckt sich jeder Schenkel 9a, 9b gleichfalls unter einem Winkel zum Steg 8, wobei der Winkel bevorzugt in einem Bereich von 70° bis 80° liegt. Der im übrigen geradlinige Steg 8 ist im Vergleich zur Dicke der Schenkel 9a, 9b schmäler. Der Übergang von Steg auf Schenkel 9a, 9b ist an der Innenseite gleichfalls gerundet, wobei der Radius geringer als der Wölbungsradius am Außenumfang im Bereich des Übergangs vom Steg zu den Schenkeln ist.

Diese Querschnittsform der Einpreßzone 7 läßt sich sehr einfach aus dem für den Steckerstift verwendeten Drahtmaterial mit quadratischem Querschnitt herstellen, wobei das Ausgangsmaterial in Fig. 2 strichliert dargestellt und mit 11 bezeichnet ist. Die beiden Prägewerkzeuge 12a, 12b besitzen jeweils mit den Außenkonturen der dargestellten Querschnittsform der Einpreßzone 2 übereinstimmende Prägeflächen.

Im einzelnen ergeben sich bei dieser Querschnittsform zwei Gelenkstellen 13a und 13b an den beiden Stegenden, um welche gewissermaßen eine definierte Verschwenkung der Schenkel 9a, 9b stattfindet, wenn der Steckerstift in die jeweilige Öffnung der Leiterplatte eingepreßt wird. Je nach dem Grad der Toleranzabweichung erfolgt eine mehr oder weniger starke Verschwenkung der beiden Schenkel nach innen, so daß diese nach dem Einsetzen des Kontaktstifts in die Öffnung der Leiterplatte unter elastischem Anpreßdruck nach außen federn und entsprechend an der Innenwand der Öffnung anliegen. Dadurch wird ein sehr fester Preßsitz des Kontaktstifts innerhalb der Leiterplatte bei geringen Einpreßkräften erzielt, welcher wiederum lösbar ist, wenn reparaturbedingt ein Austauschen der Kontaktstifte erforderlich ist.

Die Herstellung der Kontaktstifte ist die folgende. Verwendet wird Drahtmaterial mit quadratischem Querschnitt entsprechend dem Querschnitt des späteren Kontaktstifts. Das Drahtmaterial wird von einem Coil abgezogen, im Bereich der Einpreßzone mittels der beiden Prägematrizen 12a, 12b geprägt und anschließend auf Länge des Kontaktstifts durch eine Schneideinheit abgeschnitten. Weitere Bearbeitungsvorgänge fallen nicht an.

Der Kontaktstift gemäß Fig. 2 zeichnet sich dadurch aus, daß an den Enden eines zentralen Stegs Gelenkstellen ausgebildet sind, um welche an den Enden des Stegs angeordnete Schenkel beim Einpressen in die Öffnung der Leiterplatten nach innen schwenken können. Der Grad der Schwenkung ist dabei abhängig vom Übermaß oder Untermaß des Öffnungsdurchmessers. Die Querschnittsform läßt sich sehr einfach herstellen. Ferner ergibt sich nicht nur ein sehr fester Preßsitz bei geringen Einpreßkräften, sondern ermöglicht die Querschnittsform auch eine schonende Behandlung der Öffnungsränder der Leiterplatte, so daß Beschädigungen der Leiterplatte beim Einpressen von Kontaktstiften ausgeschlossen sind. Begünstigt wird dies insbesondere durch die ballige Form der Außenseite der Schenkel sowie durch den bogenförmigen Übergang vom Stegende zu den Schenkeln, der durch eine Rundung gebildet ist. In dieselbe Richtung wirkt die Maßnahme, daß die Schenkel sich zu ihrem freien

**0132704**

Ende hin verjüngen, also zu dem Bereich hin, der bei Maßunterschreitung des Öffnungsdurchmessers am weitesten relativ nach innen zu verformen ist. Insgesamt ergibt sich
dadurch eine sehr gute Anpassung der Einpreßzone an die
Öffnungswand, wodurch örtliche Eindrückungen in der Öffnungswand der Leiterplatte vermieden werden.

PATENTANSPRÜCHE:

1. Kontaktstift für elektronische Bauteile, insbesondere Leiterplatten, der mit Preßsitz in einer Öffnung der Leiterplatte einsteckbar ist, wobei der Sitzabschnitt des Stifts in der Leiterplatte mit mindestens zwei Außenabschnitten am Rand der Leiterplattenöffnung anliegt,

dadurch g e k e n n z e i c h n e t ,

daß der Kontaktstift im Sitzabschnitt (1) mit einer zentralen Stauchungszone (S) versehen ist, die sich im wesentlichen über die axiale Länge des Sitzabschnitts erstreckt.

2. Kontaktstift nach Anspruch 1,
dadurch g e k e n n z e i c h n e t ,
daß die Außenabschnitte (4) des Sitzabschnitts (1) durch die Stauchungszone (S) miteinander verbunden sind und abgerundete Außenkanten (5) zur Anlage am Rand der Leiterplattenöffnung aufweisen.

3. Kontaktstift nach einem der vorhergehenden Ansprüche,
dadurch g e k e n n z e i c h n e t ,
daß der Steg (2) mit gleichmäßiger Dicke (D) ausgebildet ist.

4. Kontaktstift nach einem der vorhergehenden Ansprüche,
dadurch g e k e n n z e i c h n e t ,
daß der Steg (2) mit einer trompetenförmigen Aufweitung (3) in die Außenabschnitte (4) übergeht.

5. Kontaktstift nach einem der vorhergehenden Ansprüche,
dadurch g e k e n n z e i c h n e t ,
daß der Sitzabschnitt (1) im wesentlichen einen H-förmigen Querschnitt aufweist, wobei die H-Schenkel durch die beiden Außenabschnitte (4) und der H-Steg durch die Stauchungszone (S) gebildet ist.

-2-

6. Kontaktstift nach einem der vorhergehenden Ansprüche,

dadurch gekennzeichnet,

daß die Außenabschnitte im wesentlichen rechteckförmigen Grundriß mit zwei abgerundeten Außenkanten (5) aufweisen.


7. Kontaktstift für elektronische Bauteile, insbesondere Leiterplatten mit insbesondere quadratischem Stiftquerschnitt, der zur festen Aufnahme in einer Öffnung mit einer elastisch deformierbaren, aus dem Drahtmaterial geprägten Einpreßzone mit einer vom Stiftquerschnitt abweichenden Querschnittsform versehen ist, die einen Steg mit an den Stegenden seitlich abstehenden Schenkeln (S/Z-Form) zur Anlage an der Wand der Steckeröffnung aufweist, deren Kontaktzone mit der Öffnungswand nach außen ballig geformt ist,

dadurch gekennzeichnet,

daß der Übergang vom Steg (8) zu den Schenkeln (9a, 9b) durch eine Rundung gebildet ist, die sich vom jeweiligen Stegende bis in die ballige Kontaktzone (10) fortsetzt.


8. Steckerstift nach einem der vorhergehenden Ansprüche,

dadurch gekennzeichnet,

daß die Schenkel (9a, 9b) sich zu ihrem freien Ende von der Außenseite her verjüngen.


9. Verfahren zur Herstellung eines Kontaktstifts nach einem der vorhergehenden Ansprüche, bei welchem der Sitzabschnitt aus Drahtmaterial mit vorzugsweise quadratischem oder rechteckförmigen Querschnitt geprägt ist,

dadurch gekennzeichnet,

daß die Prägung durch zwei gegenüberliegende Prägestempel erfolgt, deren Stempelfläche im wesentlichen die radiale Abmessung des Stegs besitzen.

10.   Verfahren nach Anspruch 9,
dadurch   g e k e n n z e i c h n e t ,
daß ein Drahtmaterial mit abgerundeten Kanten verwendet wird.

Figur 1

Fig. 2